## Europäisches Patentamt

## European Patent Office

## Office européen des brevets

(11) Publication number: **0 109 139**
**B1**

# EUROPEAN PATENT SPECIFICATION

(45) Date of publication of patent specification: **13.09.89**

(51) Int. Cl.⁴: **G 11 C 8/00**

(21) Application number: **83303858.1**

(22) Date of filing: **01.07.83**

(54) **Semiconductor memory with charge pump circuit.**

(30) Priority: **01.07.82 JP 114244/82**

(43) Date of publication of application:
**23.05.84 Bulletin 84/21**

(45) Publication of the grant of the patent:
**13.09.89 Bulletin 89/37**

(84) Designated Contracting States:
**DE FR GB**

(56) References cited:
**EP-A-0 030 813**
**FR-A-2 278 208**
**IEEE JOURNAL OF SOLID-STATE CIRCUITS,
vol. SC-16, no. 5, October 1981, pages 492-498,
IEEE, New York, US; M. TANIGUCHI et al.:
"Fully boosted 64K dynamic RAM with
automatic and self-refresh"**

(73) Proprietor: **FUJITSU LIMITED**
**1015, Kamikodanaka Nakahara-ku
Kawasaki-shi Kanagawa 211 (JP)**

(72) Inventor: **Nozaki, Shigeki**
**Mezon Hisasue 203, 473, Hisasue
Takatsu-ku Kawasaki-shi Kanagawa 213 (JP)**
Inventor: **Nakano, Tomio**
**11-2-12-404 Shirahatadai 1-chome
Miyamae-ki Kawasaki-shi Kanagawa 213 (JP)**
Inventor: **Kabashima, Katsuhiko**
**137, Akiba-cho
Mizusawa-shi Iwate 023 (JP)**

(74) Representative: **Fane, Christopher Robin King
et al
HASELTINE LAKE & CO. Hazlitt House 28
Southampton Buildings Chancery Lane
London, WC2A 1AT (GB)**

Courier Press, Leamington Spa, England.

# Description

The present invention relates to a semiconductor device and more particularly to an output circuit thereof.

In a semiconductor dynamic memory, various clocks are used to actuate the respective parts of the memory in predetermined relationships of timing. In some devices the power source voltage is reduced from 12 V to a level of 5 V and the element size is reduced. Accordingly, the accumulated charge in each memory cell is very small. In a device where the size and the voltage of the power source are thus reduced, in order to increase the quantity of the charge stored in cells and cause the cells to exhibit their abilities sufficiently and stably the clock amplitudes are increased to a value greater than the power source voltage. For attaining this purpose, there have often been used a bootstrap circuit and a charge-pumping circuit.

Circuits for boosting the voltage across a load capacitor above the power supply voltage are described in EP—A—0030813. These circuits use an additional delay circuit which only applies a clock pulse to the boosting circuit when the boosting capacitor is charged.

However, an output-level guaranteeing circuit utilizing a charge-pumping circuit may involve a certain problem at the time of application of power. In some arrangements, a clock pulse for the charge-pumping circuit is led out of a substrate bias-voltage generating circuit, and this substrate bias-voltage generating circuit starts operation substantially simultaneously with the application of power source voltage so that the clock pulse is produced more or less simultaneously with the application of power. However, clock pulses for actuating a buffer circuit connected before the output circuit are led out of predetermined stages of the various clock pulse generators connected in multiple stages. Therefore, in these clock pulses, predetermined logic levels are only attained some time after application of the power source voltage. When these clock pulses for actuating a buffer circuit are all at a low level, the output is in the floating state.

When the clock pulse of the charge-pumping circuit becomes high with the rising of the power source voltage, the output voltage level rises, for a reason explained in detail later. If the output voltage level rises in such a manner, it sometimes happens that an abnormal current flows, and short circuiting of the power source may occur.

It is desirable to protect against such erroneous operation at the time of application of the power source voltage.

According to one aspect of the present invention there is provided a semiconductor device provided with a buffer, which buffer comprises a first transistor for pulling up the output terminal voltage of the buffer, a second transistor for pulling down the output terminal voltage, and a charge-pumping circuit connected to the output terminal in order to maintain the output terminal voltage at a level higher than the power source voltage by charge-pumping when the output terminal voltage is at a high level, wherein, after application of the power source voltage to the device, there is a period where the charge-pumping circuit is operating but an adequate clock signal has not yet been applied to the first and second transistors so that they are both off and the output is floating, characterised in that the device further comprises a circuit for pulling down the output terminal voltage during the period from the point of application of power to the point of initiation of supply of an adequate input signal to the buffer.

According to another aspect there is provided a semiconductor device comprising a buffer having a first transistor for pulling up the output terminal voltage of the buffer, a second transistor for pulling down the output terminal voltage, and a charge-pumping circuit connected to the buffer circuit, wherein after application of the power source voltage to the device, there is a period where the charge-pumping circuit is operating but an adequate clock signal has not yet been applied to the first and second transistors so that they are both off and the output is floating, characterised in that the output of the charge-pumping circuit is connected to the gate of the first transistor and in that the device further comprises a circuit for pulling down the output of the charge-pumping circuit during the period from the point of application of power to the point of initiation of supply of an adequate input signal to the buffer.

Reference will now be made, by way of example, to the accompanying drawings, in which,

Figure 1 is a circuit diagram illustrating one example of a conventional buffer having an output connected to a charge-pumping circuit.

Figures 2A and Fig. 2B are time charts illustrating the operation of the circuit shown in Fig. 1;

Figure 3 is a circuit diagram showing a circuit for generating a clock pulse for the charge-puming circuit shown in Fig. 1;

Figure 4 is a circuit diagram showing a circuit for generating various clock pulses for the buffer shown in Fig. 1;

Figure 5A and Fig. 5B are circuit diagrams illustrating one embodiment of the present invention;

Figure 6 is a time chart illustrating the operation of the circuits shown in Fig. 5;

Figure 7 is a circuit diagram illustrating another embodiment of the present invention.

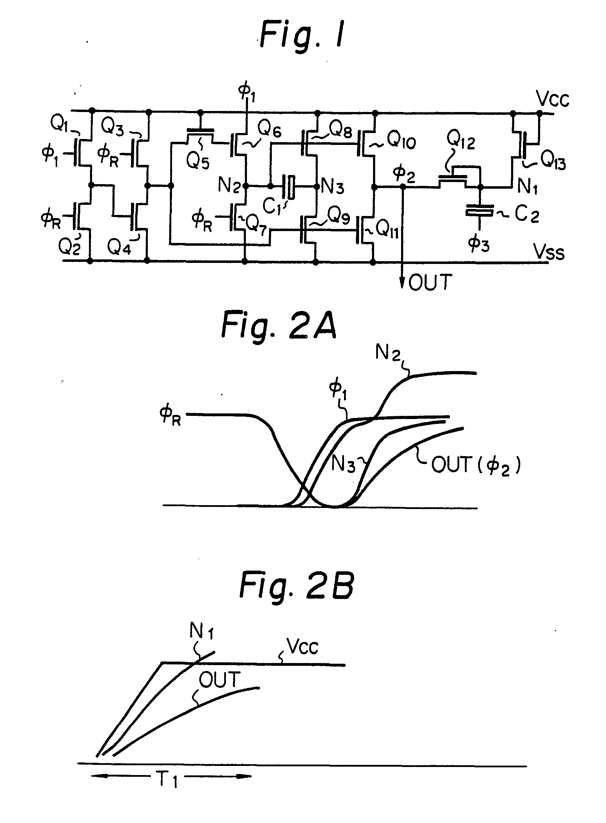

Figure 1 shows a circuit for generating a second clock pulse $\phi_2$ which rises on the receipt of a first clock pulse $\phi_1$ and drops on the receipt of a reset clock pulse $\phi_R$. In Fig. 1, Q1 through Q13 represents metal-oxide semiconductor (MOS) transistors, C1 and C2 represent capacitors, Vcc and Vss represent H (high) and L (low) levels of a 5V power source, and OUT represents an output. When the clock pulse $\phi_R$ is put in this circuit, the transistors Q2 and Q3 are turned on, the transistor Q4 is turned off, the transistors Q9 and Q11 are turned on, the transistor Q7 is turned on, the transistors Q8 and Q10 are turned off, and the voltage $\phi_2$ of the output is maintained at a low level L. The gate of the transistor Q6 is charged at a high level H through the gate Q5. When the clock pulse $\phi_1$ rises and the clock pulse $\phi_R$ drops as shown in Fig. 2A, the transistor Q1 is turned on, the transistors Q2, Q3, and Q7 are turned off, the transistor Q4 is turned on, the transistors Q8 and Q10 are turned on, the transistors Q9 and Q11 are turned off, and the output OUT ($\phi_2$) as shown in Fig. 2A is maintained at a high level H. In Fig. 2A, the relationships among the clock pulses $\phi_1$, and $\phi_R$, the potentials at nodes $N_2$ and $N_3$, and the output $\phi_2$ are illustrated. As is shown in Fig. 2A, the potential level at the node $N_2$ is placed at a level higher than the electric source voltage Vcc so that the output level of the output $\phi_2$ is obtained. In the circuit shown in Fig. 1, turning on of the transistors Q8 and Q10 is accomplished by the input of the clock pulse $\phi_1$ in the gates of these transistors through the transistors Q6, and turning on of the transistor Q6 is accomplished by the charge given to the gate of this transistor through the transistor Q5. However, since this charge is discharged through the transistor Q5 when the transistor Q4 is turned on, the transistor Q6 is presently turned off. Accordingly, turning on of the transistors Q8 and Q10 is only maintained by the charge stored in the capacitor C1, and when this charge is dissipated by a junction leak or transistor leak, the transistors Q8 and Q10 are turned off.

The clock pulse $\phi_3$ is generated for actuating the charge-pumping circuit including transistors Q12 and Q13 and the capacitor C2. More specifically, when the clock pulse $\phi_3$ is a low level L, the capacitor C2 is charge through the Vcc and Q13 and when the clock pulse $\phi_3$ is a high level H, the charge of this capacitor C2 charges the output OUT through the transistor Q12. The frequency of the clock pulse $\phi_3$ is high, and, therefore, the above-mentioned pumping operation is repeated at a high speed. When the clock pulse $\phi_R$ is put in the circuit, as was pointed out hereinbefore, the transistor Q11 is turned on, and, hence, the level of the output OUT is reduced to a low level L.

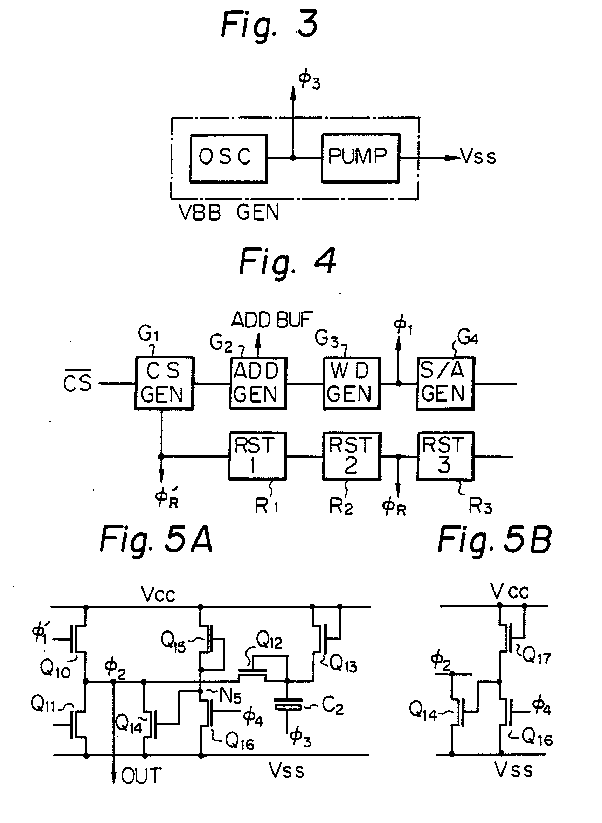

In a stationary state where the power source voltage Vcc is in the normal state, operation is carried out in the above-mentioned manner. However, just after application of the power source voltage, the operation state is as follows. Namely, the clock pulse $\phi_3$ is led out of a substrate bias-voltage generating circuit $V_{BB}$GEN. As is shown in Fig. 3, the circuit $V_{BB}$GEN comprises an oscillator OSC and a pumping circuit PUMP. Substantially simultaneous with application of the power source voltage Vcc, the circuit $V_{BB}$GEN starts operation, and hence, the clock pulse $\phi$ is simultaneously produced. In contrast, the clock pulses $\phi_1$ and $\phi_R$ are led out of predetermined stages of various clock generators G1, G2, ... and R1, R2, ... connected in multiple stages, as shown in Fig. 4.. Accordingly, in these clock pulses $\phi_1$ and $\phi_R$,

predetermined logic levels are hardly attained at the time of application of the power source voltage. Incidentally, in Fig. 4, $\overline{CS}$ represents a chip-select bar signal, ADDBUF represents an address buffer, WD represents a word decoder, S/A represents a sense amplifier, and RST represents a reset. When both the clock pulse $\phi_1$ and $\phi_R$ are at a low level L, the transistors Q10 and Q11 are kept in the "off" state and the output OUT is in the floating state. If the clock pulse $\phi_3$ is generated simultaneous with the rising of the Vcc, the transistor Q13 is turned on, though insufficiently, and the capacitor C2 is charged by the Vcc when the clock pulse $\phi_3$ is a low level and the capacitor C2 charges the output OUT through the transistors Q12 when the clock pulse $\phi_3$ is at a high level H. The capacitor C2 repeats this operation, and the voltage at the node N1 rises as indicated in the portion T1 of Fig. 2B. Also, the voltage of the output OUT is caused to rise. If the output OUT, that is, the clock pulse $\phi_2$, rises in this manner, operation of.the buffer to be actuated on the receipt of the clock pulse $\phi_2$ is still insufficient, and other clock pulses to be supplied are not yet supplied. Accordingly, it sometimes happens that an abnormal current flows. For example, in the case where the first and second transistors for receiving the clock pulse $\phi_2$ and other clock pulses are connected in series between the terminals of the power source and short circuiting of the power source is prevented since one of the transistors is turned off by supply of the other clock pulse to the other transistor when the clock signal is supplied to one transistor, if the clock pulse $\phi_2$ is supplied for the above-mentioned reason before the other clock pulses are supplied, both the first and second transistors are turned on the short circuiting of the power source occurs.

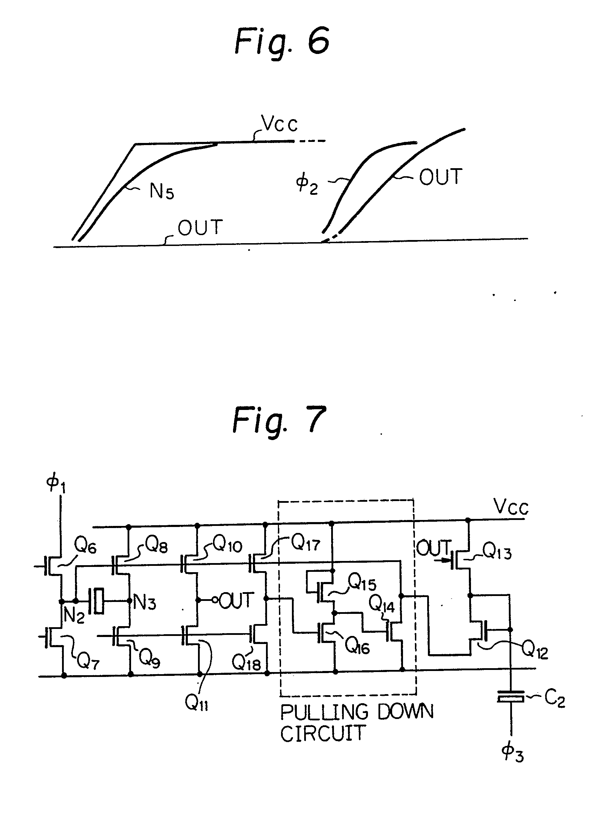

Figure 5A shows an embodiment of the present invention. In Fig. 5A, Q10 and Q11 represents output stage transistors of the buffer or clock generator shown in Fig. 1, OUT represents the output of the buffer or clock generator, and Q12, Q13, and C2 form a charge-pumping circuit for the output OUT. In the present invention, an MOS transistor Q14 is disposed to pull down the output terminal voltage to a low voltage line Vss of the power source. The transistors Q15 and Q16 are MOS transistors for controlling the gate voltage of the transistor Q14. The transistor Q15 is a depletion-type transistor, but an enhancement-type transistor as shown in Fig. 5B may be used. However, in this case, the gate of this transistor is connected to the high voltage side. The transistor Q16 is an enhancememt-type transistor, and a clock pulse $\phi_4$ is received by the gate of this transistor. Any clock pulse may be used as the clock pulse $\phi_4$ if it is of the same phase as that of the clock pulse $\phi_2$. For example, a clock pulse $\phi_1'$ to be supplied in the transistor Q10 or the output clock pulse $\phi_2$ per se may be used. In the case of $\phi_4 = \phi_1'$, even if the power source voltage is applied and operation of the pumping circuit formed by Q12, Q13, and C2 is started, the clock pulse $\phi_4$ is not supplied at this point, that is, the

clock pulse $\phi_4$ is at a low level, and the transistor Q16 is turned off and the node N5 is pulled up by the transistor Q15, which is normally turned on, with the result that the node N5 rises together with the Vcc as shown in Fig. 6. Accordingly, the transistor Q14 is turned on and the output terminal voltage OUT is pulled down to a low voltage line Vss of the power source. Therefore, the output OUT is maintained at a low level L. When the clock pulse $\phi_1'$ is supplied, the transistor Q10 and Q16 are turned on and the transistor Q11 and Q14 are turned off. At this point, the output terminal voltage OUT is no longer pulled down by the transistor Q14. Instead, the output terminal voltage OUT is pulled up by the transistor Q10 and the output OUT is caused to rise, whereby generation of the output before supply of the clock pulse, which results in erroneous operation in the subsequent circuit, can be prevented.

In the case where the output clock pulse $\phi_2$ is used as the clock pulse $\phi_4$, the mutual conductance of the transistor Q14 is made smaller than that of the transistor Q10. Namely, the resistance of Q14 is made higher than that of Q10. Even if the resistance of Q14 is high, the rising of the output OUT due to incomplete pumping at the time of the rising of the power source voltage Vcc can be controlled sufficiently. When the clock pulse $\phi_1'$ is than supplied to turn on the transistor Q10 and turn off the transistor Q11, the output terminal voltage OUT is pulled up to the power source voltage Vcc by the transistor Q10 and the output voltage OUT rises. Accordingly, the transistor Q16 is turned on and the transistor Q14 is turned off, and the output terminal voltage is no longer pulled down. In short, a kind of positive feedback is applied to the output OUT.

Figure 7 shows another embodiment of the present invention. In Fig. 7, the same elements as those in Fig. 5A are represented by the same symbols as those in Fig. 5A. In Fig. 5A, the circuit for pulling down the output terminal voltage is indirectly connected to the output of the buffer circuit, that is, the gate of the transistor Q16 is connected via transistors Q17 and Q18 to the output of the buffer circuit, and the connecting point between the drain of the transistor Q14 and the source of the transistor Q14 is connected to the node N2. In Fig. 7, the node N2 to be pumped is pulled down so that the same effect as that produced by the circuit shown in Fig. 5A can be obtained.

As is apparent, in the foregoing embodiments of the present invention, since the first and second transistors at the output of the buffer to be pumped are prevented from conducting simultaneously before the start of normal operation, the generation of an abnormal output at the time of application of the power source voltage is protected against and erroneous operation in a subsequent circuit can be avoided.

## Claims

1. A semiconductor device provided with a buffer, which buffer comprises a first transistor (Q10) for pulling up the output terminal voltage of the buffer, a second transistor (Q11) for pulling down the output terminal voltage, and a charge-pumping circuit (Q12, Q13, C2) connected to the output terminal in order to maintain the output terminal voltage at a level higher than the power source voltage by charge pumping when the output terminal voltage is at a high level, wherein, after application of the power source voltage to the device, there is a period where the charge-pumping circuit (Q12, Q13, C2) is operating but an adequate clock signal has not yet been applied to the first and second transistors (Q10, A11) so that they are both off and the output is floating, characterised in that the device further comprises a circuit (Q14—Q17 in Figure 5) for pulling down the output terminal voltage during the period from the point of application of power to the point of initiation of supply of an adequate input signal to the buffer.

2. A semiconductor device comprising a buffer having a first transistor (Q10) for pulling up the output terminal voltage of the buffer, a second transistor (Q11) for pulling down the output terminal voltage, and a charge-pumping circuit (Q12, Q13, C2) connected to the buffer circuit, wherein after application of the power source voltage to the device, there is a period where the charge-pumping circuit (Q12, Q13, C2) is operating but an adequate clock signal has not yet been applied to the first and second transistors (Q10, Q11) so that they are both off and the output is floating, characterised in that the output of the charge-pumping circuit is connected to the gate of the first transistor (Q10) and in that the device further comprises a circuit (Q14—Q18 in Figure 7) for pulling down the output of the charge-pumping circuit during the period from the point of application of power to the point of initiation of supply of an adequate input signal to the buffer.

3. A semiconductor device according to any one of claims 1 or 2, wherein said pulling-down circuit comprises a pulling-down MOS transistor (Q14) which is connected between the output of said pumping circuit and a reference level, a depletion-type MOS transistor (Q15) and an enhancement-type MOS transistor (Q16) which are connected in series between said power source voltage and a reference level, the gate of said depeletion-type MOS transistor being connected to a connection point of said depeletion-type MOS transistor and said enhancement-type MOS transistor, said connection point being connected to the gate of said pulling-down MOS transistor, and the gate of said enhancement-type MOS transistor receiving a clock pulse having the same phase as that of said output terminal voltage.

4. A semiconductor device according to any one of claims 1 and 2, wherein said pulling-down circuit comprises a pulling-down MOS transistor (Q14) which is connected between the output of said pumping circuit and a reference level, a first enhancement-type MOS transistor (Q17) and a second enhancement-type MOS transistor (Q16) which are connected in series between said power source voltage and a reference level, the gate of said first enhancement-type MOS transistor being connected to said power source voltage, the connection point of said first and second enhancement-type MOS transistors being connected to the gate of said pulling-down MOS transistor (Q14), and the gate of said second enhancement-type MOS transistor receiving a clock pulse having the same phase as that of said output terminal voltage.

**Patentansprüche**

1. Halbleitervorrichtung mit einem Puffer, welcher Puffer einen ersten Transistor (Q10) zum Hochziehen der Ausgangsanschlußspannung des Puffers umfaßt, und einen zweiten Transistor (Q11) zum Runterziehen der Ausgangsanschlußspannung, und eine Ladungspumpschaltung (Q12, Q13, C2), die mit dem Ausgansangsanschluß verbunden ist, um die Ausgansanschlußspannung durch Ladungspumpen auf einem Pegel oberhalb der Energiequellenspannung zu halten, wenn die Ausgangsanschlußspannung auf einem hohen Pegel ist, bei welcher, nach Anwendung der Energiequellenspannung auf die Vorrichtung, es eine Periode gibt, während welcher die Ladungspumpschaltung (Q12, Q13, C2) arbeitet, jedoch ein adäquates Taktsignal noch nicht den ersten und zweiten Transistoren (Q10, Q11) zugeführt ist, so daß sie beide aus sind und der Ausgang schwimmend ist, dadurch gekennzeichnet, daß die Vorrichtung ferner eine Schaltung (Q14—Q17 in Figur 5) umfaßt, um die Ausgangsanschlußspannung während dre Periode von dem punkt der Anwendung von Energie zu dem Punkt der Initiierung der Zuführung eines adäquaten Eingangssignals zu dem Puffer herabzuziehen.

2. Halbleitervorrichtung mit einem Puffer, der einen ersten Transistor (Q10) umfaßt, um die Ausgangsanschlußspannung des Puffers hochzuziehen, einen zweiten Transistor (Q11), um die Ausgangspumpschaltung (Q12, Q13, C2), die mit der Pufferschaltung verbunden ist, bei welcher nach Anwendung der Energiequellenspannung auf die Vorrichtung es eine Periode gibt, während welcher die Ladungspumpschaltung (Q12, Q13, C2) in Betrieb ist, jedoch ein adäquates Taktsignal noch nicht auf die ersten und zweiten Transistoren (Q10, Q11) angewendet wurde, so daß sie beide aus und der Ausgang schwimmend ist, dadurch gekeknzeichnet, daß der Ausgang der Ladungspumpschaltung mit dem Gate des ersten Transistors (Q10) verbunden ist, und daß die Vorrichtung ferner eine Schaltung (Q14—Q18 in Figur 7) umfaßt, um den Ausgang der Ladungspumpschaltung während der Periode von dem Punkt der Anwendung von Energie zu dem Punkt der Initiierung der Zuführung eines adäquaten Eingangssignals zu dem Puffer runterzuziehen.

3. Halbleitervorrichtung nach einem der Ansprüche 1 oder 2, bei der die genannte pull-down-Schaltung einen ersten pull-down-MOS-Transistor (Q14) umfaßt, der zwischen dem Ausgang der genannten Pumpschaltung und einem Referenzpegel angeschlossen ist, einen Verarmungstyp-MOS-Transistor (Q15) und einen Anreicherungstyp-MOS-Transistor (Q16), die in Reihe zwischen der genannten Energiequellenspannung und einem Referenzpegel verbunden sind, wobei das Gate des Verarmungstyp-MOS-Transistors mit einem Verbindungspunkt des genannten Verarmungstyp-MOS-Transistors und des genannten Anreicherungstyp-MOS-Transistor verbunden ist, und der genannte Verbindungspunkt mit dem Gate des pull-down-MOS-Transistors verbunden ist, und das Gate des Anreicherungstyp-MOS-Transistors einen Taktimpuls empfängt, welcher dieselbe Phase hat wie die genannte Ausgangsanschlußspannung.

4. Halbleitervorrichtung nach einem der Ansprüche 1 oder 2, bei der die pull-down-Schaltung einen pull-down-MOS-Transistor (Q14) umfaßt, der zwischen dem Ausgang der genannten Pumpschaltung und einem Referenzpegel angeschlossen ist, einen ersten Anreicherungstyp-MOS-Transistor (Q17) und einen zweiten Anreicherungstyp-MOS-Transistor (Q16), die in Reihe zwischen der genannten Energiequellenspannung und einem Referenzpegel verbunden sind, wobie das Gate des genannten ersten Anreicherungstyp-MOS-Transistors mit der genannten Energiequellenspannung verbunden ist, der Verbindungspunkt der genannten ersten und zweiten Anreicherungstyp-MOS-Transistoren mit dem Gate des pull-down-MOS-Transistors (Q14) verbunden ist, und das Gate des zweiten Anreicherungstyp-MOS-Transistors einen Taktimpuls empfängt, welcher dieselbe Phase hat wie die genannte Ausgangsanschlußspannung.

**Revendications**

1. Dispositif semi-conducteur comportant un tampon, ce tampon comprenant un premier transistor (Q10) destiné à élever la tension à la borne de sortie du tampon, un second transistor (Q11) destiné à abaisser la tension à la borne de sortie et un circuit de pompage (Q12, Q13, C2) connecté à la borne de sortie de manière à maintenir la tension à borne de sortie à un niveau supérieur à la tension d'alimentation par pompage de charge quand la tension à la borne de sortie est à un niveau haut, dans lequel, après l'application de la tension d'alimentation au dispositif, il existe une période dans laquelle le circuit de pompage de charge (Q12, Q13, C2) fonctionne mais un signal d'horloge adéquat n'a pas encore été appliqué au premier et au second transistors (Q10, Q11) de sorte qu'ils sont tous deux bloqués et que la sortie est flottante, caractérisé en ce que le dispositif comporte en outre un circuit (Q14—Q17) de la figure 5) destiné à abaisser la tension à la borne de sortie pendant la période depuis le point d'application de la tension jusqu'au point de déclenchement de l'application d'un signal d'entrée adéquat au tampon.

2. Dispositif semi-conducteur comportant un tampon qui comprend un premier transistor (Q10) destiné à élever la tension à la borne de sortie du tampon, un second transistor (Q11) destiné à abaisser la tension à la borne de sortie et un circuit de pompage (Q12, Q13, C2) connecté au circuit tampon, dans lequel, après l'application de la tension d'alimentation au dispositif, il existe une période dans laquelle le circuit de pompage de charge (Q12, Q13, C2) fonctionne mais aucun signal d'horloge adéquat n'a encore été appliqué au premier et au second transistor (Q10, Q11) de sorte qu'ils sont tous deux bloqués et que la sortie est flottante, caractérisé en ce que la sortie du circuit de pompage de charge est connectée á la grille du premier transistor (Q10) et en ce que le dispositif comporte en outre un circuit (Q14—Q18 de la figure 7) destiné à abaisser la sortie du circuit de pompage de charge pendant la période depuis le point d'application de l'alimentation jusqu'au point de déclenchement de l'application d'un signal d'entrée adéquat au tampon.

3. Dispositif semi-conducteur selon l'une quelconque des revendications 2 et 3, dans lequel ledit circuit d'abaissement comporte un transistor (Q14) MOS d'abaissement que est connecté entre la sortie dudit circuit de pompage et un niveau de référence, un transistor MOS (Q15) du type appauvri et un transistor MOS (Q16) du type enrichi qui sont connectés en série entre ladite tension d'alimentation et un niveau de référence, la grille dudit transistor MOS appauvri étant connectée à un point de connexion du transistor MOS du type appauvri et dudit transistor MOS du type enrichi, ledit point de connexion étant connecté à la grille dudit transistor MOS d'abaissement et la grille dudit transistor MOS du type enrichi recevant une impulsion d'horloge ayant la même phase que celle de ladite tension à la borne de sortie.

4. Dispositif semi-conducteur selon l'une quelconque des revendications 1 et 2, dans lequel ledit circuit d'abaissement comporte un transistor MOS d'abaissement (Q14) qui est connecté entre la sortie dudit circuit de pompage et un niveau de référence, un premier transistor MOS du type enrichi (Q17) et un second transistor MOS du type enrichi (Q16) qui sont connectés en série entre ladite tension d'alimentation et un niveau de référence, la grille dudit premier transistor MOS du type enrichi étant connectée à ladite tension d'alimentation, le point de connexion dudit premier et dudit second transistors MOS du type enrichi étant connecté à la grille dudit transistor MOS d'abaissement (Q14) et la grille dudit transistor MOS du type enrichi recevant une impulsion d'horloge ayant la même phase que celle de ladite tension à la borne de sortie.

# Fig. I

# Fig. 2A

# Fig. 2B

# Fig. 3

# Fig. 4

# Fig. 5A

# Fig. 5B

## Fig. 6

## Fig. 7

PULLING DOWN
CIRCUIT

3